# EUROPÄISCHE PATENTSCHRIFT

(11) **EP 2 491 772 B1**
(45) Veröffentlichungstag und Bekanntmachung des Hinweises auf die Patenterteilung: **05.04.2017**
(21) Anmeldenummer: 10765576.3
(22) Anmeldetag: 28.09.2010
(51) Int. Cl.: H05K 7/14, H02K 5/22

(54) **ELEKTROGERÄT**
ELECTRICAL DEVICE
APPAREIL ÉLECTRIQUE

(30) Priorität: 21.10.2009 DE 102009050232
(43) Veröffentlichungstag der Anmeldung: 29.08.2012
(73) Patentinhaber: SEW-EURODRIVE GmbH & Co. KG, 76646 Bruchsal (DE)
(72) Erfinder: KIESEL, Michael, 76187 Karlsruhe (DE); ENENKEL, Ronnie, 76187 Karlsruhe (DE); JUNGINGER, Alexander, 75196 Remchingen-Wilferdingen (DE)
(86) Internationale Anmeldenummer: PCT/EP2010/005899
(87) Internationale Veröffentlichungsnummer: WO 2011/047772

(56) Entgegenhaltungen:
- EP-A2- 1 895 642
- WO-A1-00/48438
- DE-A1- 3 942 690
- DE-A1-102004 034 834
- DE-A1-102008 034 078

## Beschreibung

Die Erfindung betrifft ein Elektrogerät.

Bei Elektrogeräten ist bekannt, elektronische Schaltungen als Busteilnehmer auszuführen, denen Adressen zugeordnet werden, so dass an eine Adresse adressierte Daten von einem Teilnehmer an diejenige elektronische Schaltung übermittelt werden, welcher die Adresse zugeordnet ist.

Aus der WO 00/48438 A1 ist ein Verteilerkasten bekannt, der ein auf ein Unterteil aufsetzbares Oberteil aufweist, wobei im Oberteil eine elektronische Schaltung vorgesehen ist.

Aus der DE 10 2004 034 834 A1 ist ein Gehäusebaukasten bekannt, bei dem aus einem Baukasten mit möglichst wenig Sorten von Teilen möglichst viele verschiedene Gehäuse aufbaubar sind.

Aus der EP 1 895 642 A2 ist ein Anschlusskasten eines Elektromotors bekannt, bei dem ein Oberteil auf ein Unterteil aufsetzbar ist.

Das Dokument DE 39 42 690 A1 offenbart ein elektronisches Gerät, bei dem Funktionsbaugruppen über einen Systembus mit einer Verarbeitungseinheit verbunden sind sowie in die Funktionsbaugruppen einsteckbare Anschlussstecker, die die Funktionsbaugruppen mit Peripheriegeräten verbinden, und einen Adressenspeicher für symbolische Systembusadressen der Funktionsbaugruppen aufweisen.

Ein Steckverbindermodul zur Verbindung mit Feldgeräten, wobei in dem Steckverbindermodul Teilnehmeradressen von Feldgeräten gespeichert sind, wird in dem nachveröffentlichten Dokument DE 102008 034 078 A1 offenbart.

Der Erfindung liegt daher die Aufgabe zugrunde, Elektrogerät für eine einfache und wenig aufwendige Wartung oder Inbetriebnahme weiterzubilden.

Erfindungsgemäß wird die Aufgabe bei dem Elektrogerät nach den in Anspruch 1 angegebenen Merkmalen gelöst.

Wichtige Merkmale der Erfindung bei dem Elektrogerät, das aus Modulen zusammengesetzt ist oder zusammengesetzte Module umfasst,
wobei die Module jeweils eine Elektronikschaltung umfassen, die auf einem jeweiligen Kühlkörper aufgesetzt vorgesehen sind,
wobei Module als Teilnehmer eines Systembusses ausgebildet sind, der auch zu einer als Teilnehmer des Systembusses ausgeführten elektronischen Schaltung geführt ist,
wobei die elektronische Schaltung in einem Unterteil angeordnet ist, welches in einer Ausnehmung des Gehäuses des Elektrogeräts angeordnet ist,
wobei ein Oberteil mit dem Unterteil lösbar verbindbar ist, wobei im Oberteil ein Speicherelement angeordnet ist und Datenleitungen zum Auslesen des Speicherelements mittels der elektronischen Schaltung über eine Steckverbindung zur elektronischen Schaltung geführt werden

Von Vorteil ist dabei, dass bei Austausch des Elektrogeräts, insbesondere samt Unterteil, eine schnelle Inbetriebnahme ermöglicht ist, da die ursprüngliche Feldbus-Parameter, wie Feldbus-Adresse, Baudrate und dergleichen, des getauschten Elektrogeräts sofort nach Einbau des neuen Elektrogeräts auslesbar und verwendbar ist für das Elektrogerät. Insbesondere ist eine erneuten Einstellung nicht notwendig. Außerdem ist das Elektrogerät infolge der Kühlkörper kompakt ausbildbar, also mit wenig Masse. Hierdurch ist der Austausch ebenfalls erleichtert. Des Weiteren ist mittels des modularen Aufbaus auch ein Austausch eines defekten Moduls ermöglicht, wodurch eine schnelle und kostengünstige Wartung oder ein entsprechender Austausch ermöglicht ist.

Bei einer vorteilhaften Ausgestaltung ist das Speicherelement als elektronisches Speicherelement oder als mechanisches Speicherelement, wie DIP-Schalter oder dergleichen, ausgeführt. Von Vorteil ist dabei, dass bei der mechanischen Ausführung ein stabiler robuster Speicher und bei der elektronischen und auch mechanischen Ausführung große Datenmengen, also nicht nur die Adresse sondern auch weitere Parameter abspeicherbar und auslesbar sind, so dass sogar die Parametrierung einfach und schnell ausführbar ist.

Bei einer vorteilhaften Ausgestaltung ist im Speicherelement eine Teilnehmeradresse des Elektrogeräts zur Datenübertragung im Feldbus abspeicherbar. Von Vorteil ist dabei, dass die elektronischen Bauelemente in Form des restlichen Geräts schnell und einfach austauschbar sind im Fehlerfall. Die Verkabelung des Feldbus in der Anlage muss jedoch nicht unterbrochen werden. Nach Einsetzen des neuen Elektrogeräts muss das neue Elektrogerät nur wenige Daten, wie beispielsweise die Teilnehmeradresse, Baudrate oder dergleichen, auslesen und aktivieren als Feldbusteilnehmeradresse. Unmittelbar danach sind Daten austauschbar über den Feldbus mit weiteren Feldbusteilnehmern. Vorzugsweise wird ein CAN Bus, Profibus oder Interbus-Protokoll als Feldbusprotokoll verwendet.

Bei einer vorteilhaften Ausgestaltung sind im Oberteil Feldbus-Treiber vorgesehen und/oder dass im Oberteil eine T-förmige Verkabelung für Feldbus vorgesehen ist,
insbesondere wobei von der zugehörigen Anzapfung Feldbusleitungen über die Steckverbindung zur elektronischen Schaltung geführt sind. Von Vorteil ist dabei, dass ein Durchschleifen der Busleitungen im Oberteil ermöglicht ist. Mittels der Anzapfung sind Daten auf den Datenbus aufkoppelbar oder vom Datenbus abkoppelbar. Im Oberteil sind bis auf den Speicher und gegebenenfalls Bustreiber keine elektronischen Bauelemente vorgesehen. Die Versorgungsleitungen zur Versorgung der Bustreiber werden ebenfalls wie auch die zum Speicherelement führenden Busleitungen des Systembusses und die Feldbusleitungen mittels der Steckverbindung vom Oberteil ans Unterteil übergeben. Zusätzlich sind auch die Versorgungsleitungen für das Elektrogerät mittels der Steckverbindung vom Oberteil ans Unterteil übergebbar.

Bei einer vorteilhaften Ausgestaltung weist das Oberteil Führungszapfen, insbesondere zum Verhindern des Verkantens beim Betätigen der Steckverbindung zur Übergabe der Feldbusleitungen auf,
insbesondere in welche Verbindungsschrauben oder auch Bajonettverschlüsse zur Verbindung des Oberteils mit dem Unterteil einschraubbar sind. Von Vorteil ist dabei, dass ein Verkanten und somit ein Versagen der elektrischen Verbindungen der Busleitungen verhindert ist. Durch das sichere Übergeben der Busleitungen ist eine sichere Inbetriebnahme gewährleistet.

Bei einer vorteilhaften Ausgestaltung weist eines der Module einen Busumsetzer auf zum Umsetzen von Daten im Feldbusprotokoll in Daten im Systembusprotokoll. Von Vorteil ist dabei, dass die Module schnellen Datenaustausch untereinander durchführen können, da der Systembus ein herstellereigener Feldbus ist und somit nur die notwendigen Elemente enthält im Gegensatz zu einem öffentlich bekannten Feldbus, bei welchem sehr komplexe Protokollstrukturen realisierbar sind.

Bei einer vorteilhaften Ausgestaltung sind der Systembus, insbesondere der nach Art eines CAN-Bus aufgebaut ist, und der Feldbus ein davon unterschiedlicher Bus ist, insbesondere nach Art von Interbus, Profibus, CAN-Bus oder dergleichen. Von Vorteil ist dabei, dass eine besonders schnelle Datenübertragungsrate innerhalb des Elektrogerätes erreichbar ist, da der Systembus nur auf die Anforderungen der herstellereigenen Geräte, wie beispielsweise das Elektrogerät und die umfassten Module, abgestimmt sein muss. Außerdem ist auch der Hardware-Aufwand verringerbar bei Herstellen eines Systembusses, da auch hier nur die Anforderungen der Module und/oder des Elektrogeräts zu berücksichtigen sind.

Bei einer vorteilhaften Ausgestaltung weisen die Module, insbesondere die Kühlkörper der Module, an zwei einander gegenüberliegenden Seiten eine derartige Schnittstelle auf, dass sie miteinander in einer Linie oder Reihe verbindbar sind und somit den Boden des Elektrogeräts bilden. Von Vorteil ist dabei, dass ein modularer Aufbau erreichbar ist, wobei die Wärme der Bauteile gut abführbar ist. Außerdem ist die Schnittstelle derart gestaltet, dass die Module auch innerhalb der Linie umordenbar sind und sich dabei die Linienlänge nicht ändert.

Die Erfindung wird nun anhand von Abbildungen näher erläutert:
In der Figur 1 ist ein Anschlusssteckverbinder für ein erfindungsgemäßes Elektrogerät 35 in Schrägansicht gezeigt.

In Figur 2 ist der Anschlusssteckverbinder aus einem anderen Blickwinkel gezeigt.

In Figur 3 ist das Elektrogerät 35 schematisch skizziert.

Das Elektrogerät 35 umfasst Module K0, K1 bis Kn, wobei n eine ganze Zahl ist. Jedes Modul ist auf einer jeweiligen Grundplatte angeordnet, die als Kühlkörper fungiert und Kühlrippen aufweist. Die Grundplatten der Module weisen an zwei gegenüberliegenden Seiten jeweils eine Verbindungsschnittstelle derart auf, dass sie in einer Reihe, also Linie, miteinander dicht verbindbar sind, wobei die Kühlkörper die Rückseite des Elektrogeräts 35 bilden.

Auf der Grundplatte jedes Moduls ist eine elektronische Schaltung angeordnet, die zumindest einen Systembus, also Anschluss für Datenbus, aufweist. Die Funktionalitäten der elektronischen Schaltungen sind beispielhaft als Versorgungsmodul, Wechselrichter, Umrichter, Rückspeisemodul, Steuerungseinheit und dergleichen ausgeführt. Die durch die Kühlkörper gebildete Rückseite wird durch weitere Gehäuseteile derart zu einem Gehäuse ergänzt, dass die elektronischen Schaltung in hoher Schutzart gehäusebildend umgeben sind. Somit ist das Elektrogerät dezentral einsetzbar und wegen seiner modularen Aufbauweise an die jeweiligen lokalen Anforderungen in seiner Funktionalität anpassbar. Eine ausreichende Abfuhr von Wärme an die Umgebung ist mittels der Kühlkörper gewährleistet.

Die Versorgungsleitungen und/oder weitere Feldbusleitungen werden über ein Anschlusssteckverbinderteil zugeführt. Dabei weist das Anschlusssteckverbinderteil ein Unterteil und ein Oberteil auf, wobei das Unterteil 1 als Flanschteil derart ausgeführt ist, dass es in einer Ausnehmung des Elektrogeräts 35 einsetzbar und dicht verbindbar ist.

Das Oberteil 6 wird mit Verbindungsschrauben 7 am Unterteil 1 angeschraubt, wobei beim Verbinden des Oberteils 6 und des Unterteils 1 am Unterteil 1 vorgesehene Führungszapfen 4 vorgesehen sind, welche ein Verkanten beim zusammenführen des Oberteils und des Unterteils 1 verhindern. Besonders einfach und schnell ist ein Tausch ermöglicht, wenn eine werkzeuglose Schraubverbindung realisiert wird, beispielsweise durch Verwendung von Rändelschrauben.

Am Unterteil 1 ist eine Leiterplatte 2 mit Signalelektronik vorgesehen, die als Teilnehmer des Systembusses 33 ausgeführt ist. Das Unterteil 1 ist mittels Befestigungsschrauben 3 am Gehäuse des Elektrogeräts 35 angeschraubt.

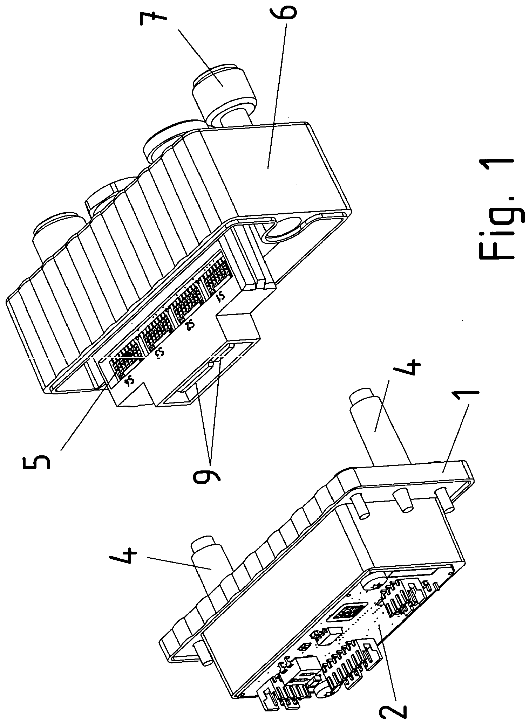

Das Oberteil 6 weist DIP-Schalter 5 auf, welche als mechanischer Speicher von Daten, wie beispielsweise Busteilnehmeradresse des Elektrogeräts 35 für den weiteren Feldbus oder weiteren Daten, vorgesehen sind. Datenleitungen von diesem mechanischen Speicher, also DIP-Schalter 5, zur auf der Leiterplatte 2 vorgesehenen elektronischen Schaltung werden über eine Steckverbindung vom Oberteil 6 ans unterteil 1 geführt. Dabei ist in Figur 1 eines der Steckverbinderteile 9 gezeigt. Das Gegensteckverbinderteil ist nicht sichtbar, aber am Unterteil 1 vorgesehen.

An Steckverbindungen, umfassend Kabeldurchführungen 8, werden Busleitungen herausgeführt beziehungsweise ins Oberteil 6.hineingeführt, so dass ein Durchschleifen der Busleitungen ermöglicht ist und mittels einer T-förmigen Verkabelung 31 innerhalb des Oberteils 6 eine Anzapfung am weiteren Feldbus ausgeführt ist. Auch dieses an der Anzapfung endenden Busleitungen werden über die Kontakte des Steckverbinderteils 9 zum Unterteil 1 und von dort weiter zu einem ersten Modul K0 geführt, das einen Busumsetzer aufweist, so dass die Daten des weiteren Feldbusses in auf dem Systembus übertragbare Daten umsetzbar sind.

Bei Ausfall oder Wartung des Elektrogeräts ist dieses neu anschließbar oder ersetzbar, wobei das Oberteil 6 in der Anlage unverändert verbleibt - wie auch die ans Oberteil 6 führenden Leitungen, insbesondere Feldbusleitungen. Somit ist es ermöglicht, dass das Feldbussystem der Anlage ungestört weiter arbeitet, auch wenn das Elektrogerät abgetrennt ist. Bei Verbinden mit dem Oberteil 6 und Inbetriebnahme des Elektrogeräts 35 wird die im Speicherelement 30 des Oberteils abgespeicherte Adresse wird über den Systembus 33 und die auf der Leiterplatte 2 vorgesehene elektronische Schaltung ausgelesen. Somit sind die Adresse und weitere Parameter sofort verfügbar und das Elektrogerät ist zum Datenaustausch über den weiteren Feldbus 34 bereit.

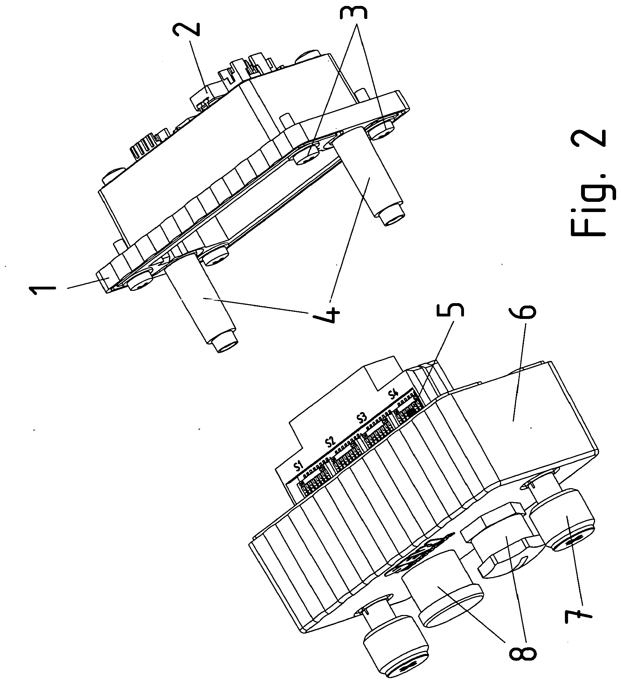

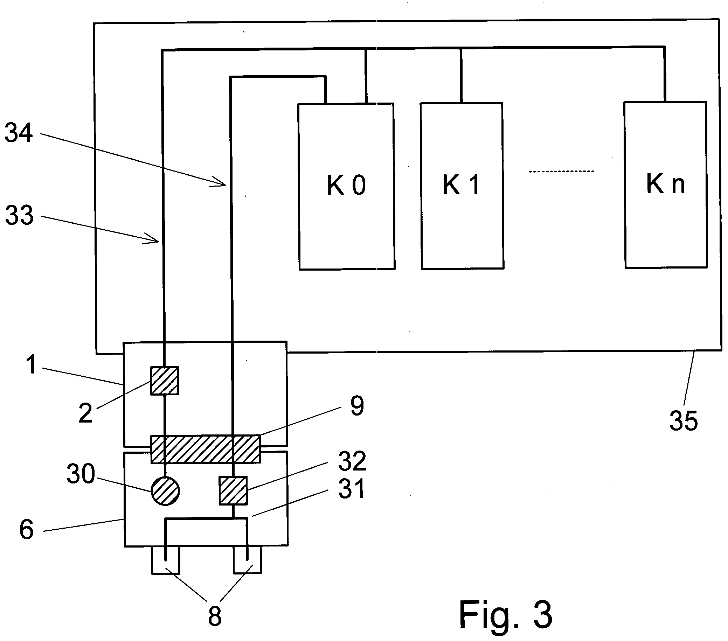

In Figur 1 und 2 ist das Speicherelement 30 als mechanischer Speicher in Form eines DIP-Schalters 5 ausgeführt. In weiteren Ausführungsbeispielen sind auch andere Ausführungen des Speicherelements vorteilhaft verwendbar, beispielsweise auch als elektronisches Speicherelement. Wie in Figur 3 ersichtlich, ist jedoch wichtig, dass das Speicherelement 30 auslesbar ist mittels der elektronischen Schaltung der Leiterplatte 2 und diese Daten dann über den Systembus weitertransportierbar sind, insbesondere zu den als Systembusteilnehmer ausgeführten Modulen.

Über den Systembus 33 sind Daten zwischen den einzelnen Modulen austauschbar. Darüber hinaus ist der Systembus 33 mit einem im Oberteil des Anschlusssteckverbinders vorgesehenen Speicherelement 30 verbunden, so dass die in diesem gespeicherten Daten auslesbar sind. Als Daten sind beispielsweise eine für das Elektrogerät vorgesehene Busteilnehmeradresse zur Teilnahme am weiteren Datenbus und/oder weitere Parameter vorgesehen.

Systembus 33 unterscheidet sich vom weiteren Feldbus 34 im Übertragungsprotokoll und in der Datenübertragungsrate. Ansonsten sind Systembus 33 und weiterer Feldbus 34 jeweils als Datenbus ausgeführt.

Im Oberteil 6 sind an der Anzapfung Feldbus-Treiber 32 vorgesehen. Alternativ sind diese aber auch im Unterteil 1, insbesondere in der auf der Leiterplatte 2 vorgesehenen elektronischen Schaltung vorsehbar oder innerhalb des Elektrogeräts 35.

In einem weiteren erfindungsgemäßen Ausführungsbeispiel ist die auf der Leiterplatte 2 vorgesehene Signalelektronik wiederum als Teilnehmer des Systembusses ausgeführt, wobei allerdings das Speicherelement 30 über die Kontakte des Steckverbinderteils 9 mit der Signalelektronik verbindbar und von dieser auslesbar ist. Dabei ist keine Systembusverbindung zwischen Speicherelement 30 und elektronischer Schaltung auf der Leiterplatte 2 vorgesehen. Die elektronische Schaltung wertet die auf den Kontakten anliegenden Spannungszustände aus, um die Informationen des Speicherinhalts des Speicherelements 30 zu erfassen.

### Bezugszeichenliste

- 1: Flanschteil des Unterteils
- 2: Leiterplatte mit Signalelektronik
- 3: Befestigungsschrauben
- 4: Führungszapfen
- 5: DIP-Schalter
- 6: Oberteil
- 7: Verbindungsschrauben
- 8: Steckverbindung mit Kabeldurchführung
- 9: Kontakte des Steckverbinderteils
- 30: Speicherelement, insbesondere elektronischer Speicher oder mechanischer Speicher
- 31: T-förmiger Verteiler für Feldbus
- 32: Feldbus-Treiber
- 33: Systembus
- 34: Feldbus
- 35: Elektrogerät

## Patentansprüche

1. Elektrogerät (35),
das aus Modulen zusammengesetzt ist oder zusammengesetzte Module umfasst,
wobei die Module jeweils eine Elektronikschaltung umfassen, die auf einem jeweiligen Kühlkörper aufgesetzt vorgesehen sind,
wobei Module als Teilnehmer eines Systembusses (33) ausgebildet sind, der auch zu einer als Teilnehmer des Systembusses (33) ausgeführten elektronischen Schaltung geführt ist,
wobei die elektronische Schaltung in einem Unterteil angeordnet ist, welches in einer Ausnehmung des Gehäuses des Elektrogeräts (35) angeordnet ist,
wobei ein Oberteil (6) mit dem Unterteil lösbar verbindbar ist, wobei im Oberteil (6) ein Speicherelement (30) angeordnet ist und Datenleitungen zum Auslesen des Speicherelements (30) mittels der elektronischen Schaltung über eine Steckverbindung (8) zur elektronischen Schaltung geführt werden,
wobei das Elektrogerät (35) ein Feldbusteilnehmer ist,
wobei das Unterteil das Unterteil eines Anschlusssteckverbinders ist und das Oberteil (6) das Oberteil (6) eines Anschlusssteckverbinders ist,
wobei die Feldbusleitungen ans Oberteil (6) führen,
wobei die Teilnehmeradresse des Elektrogeräts (35), welche zur Datenübertragung im Feldbus vorgesehen ist, im Speicherelement (30) in dem Oberteil (6) des Anschlusssteckverbinders abgespeichert ist.

2. Elektrogerät nach mindestens einem der vorangegangenen Ansprüche,
**dadurch gekennzeichnet, dass**
das Speicherelement (30) als elektronisches Speicherelement oder als mechanisches Speicherelement, wie DIP-Schalter (5) oder dergleichen, ausgeführt ist.

3. Elektrogerät nach mindestens einem der vorangegangenen Ansprüche,
**dadurch gekennzeichnet, dass**
im Oberteil (6) Feldbus-Treiber vorgesehen sind und/oder dass im Oberteil (6) eine T-förmige Verkabelung für Feldbus vorgesehen ist,
insbesondere wobei von der zugehörigen Anzapfung Feldbusleitungen über die Steckverbindung (8) zur elektronischen Schaltung geführt sind.

4. Elektrogerät nach mindestens einem der vorangegangenen Ansprüche,
**dadurch gekennzeichnet, dass**
das Unterteil Führungszapfen (4) zum Verhindern des Verkantens beim Betätigen der Steckverbindung (8) zur Übergabe der Feldbusleitungen aufweist,
insbesondere in welche Verbindungsschrauben (7) zur Verbindung des Oberteils (6) mit dem Unterteil einschraubbar sind.

5. Elektrogerät nach mindestens einem der vorangegangenen Ansprüche,
**dadurch gekennzeichnet, dass**
eines der Module einen Busumsetzer aufweist zum Umsetzen von Daten im Feldbusprotokoll in Daten im Systembusprotokoll.

6. Elektrogerät nach mindestens einem der vorangegangenen Ansprüche,
**dadurch gekennzeichnet, dass**
die Module, insbesondere die Kühlkörper der Module, an zwei einander gegenüberliegenden Seiten eine derartige Schnittstelle aufweise, dass sie miteinander in einer Linie oder Reihe verbindbar sind und somit den Boden des Elektrogeräts bilden.

## Claims

1. Electrical device (35),
which is assembled from modules or comprises assembled modules,
wherein the modules each comprise an electronic circuit which is provided mounted on a respective heat sink,
wherein modules are configured as nodes of a system bus (33) which is also led to an electronic circuit designed as a node of the system bus (33),
wherein the electronic circuit is arranged in a lower part which is arranged in a recess of the housing of the electrical device (35),
wherein an upper part (6) is detachably connectable to the lower part, wherein a memory element (30) is arranged in the upper part (6) and data lines for reading out the memory element (30) by means of the electronic circuit are led via a plug connection (8) to the electronic circuit,
wherein the electrical device (35) is a fieldbus node,
wherein the lower part is the lower part of an attachment plug connector and the upper part (6) is the upper part (6) of an attachment plug connector,
wherein the fieldbus lines lead to the upper part (6),
wherein the node address of the electrical device (35), which address is provided for data transmission in the fieldbus, is stored in the memory element (30) in the upper part (6) of the attachment plug connector.

2. Electrical device according to at least one of the preceding claims,
**characterised in that**
the memory element (30) is designed as an electronic memory element or as a mechanical memory element, such as a DIP switch (5) or the like.

3. Electrical device according to at least one of the preceding claims,
**characterised in that**
fieldbus drivers are provided in the upper part (6) and/or **in that** a T-shaped cabling for fieldbus is provided in the upper part (6),
in particular wherein fieldbus lines from the associated tapping point are led via the plug connection (8) to the electronic circuit.

4. Electrical device according to at least one of the preceding claims,
**characterised in that**
the lower part has guiding pins (4) for preventing canting upon actuation of the plug connection (8) for transfer of the fieldbus lines,
in particular into which connecting screws (7) are screwable to connect the upper part (6) to the lower part.

5. Electrical device according to at least one of the preceding claims,
**characterised in that**
one of the modules has a bus converter for converting data in the fieldbus protocol into data in the system bus protocol.

6. Electrical device according to at least one of the preceding claims,
**characterised in that**
the modules, in particular the heat sinks of the modules, have an interface at two mutually opposing sides that allows them to be interconnected in a line or a row and thereby form the bottom of the electrical device.

## Revendications

1. Appareil électrique (35),
qui est composé de modules ou comprend des modules assemblés,
sachant que les modules comprennent chacun un circuit électronique qui sont placés sur un corps de refroidissement respectif,
sachant que les modules sont conçus comme participants d'un bus système (33), qui est également dirigé vers un circuit électronique conçu comme participant du bus système (33),
sachant que le circuit électronique est disposé dans une partie inférieure qui est disposée dans un évidement du boîtier de l'appareil électrique (35),
sachant qu'une partie supérieure (6) peut être reliée de manière amovible à la partie inférieure, sachant qu'un élément de mémoire (30) est disposé dans la partie supérieure (6) et que des lignes de données sont dirigées par l'intermédiaire d'une connexion enfichable (8) vers le circuit électronique afin de lire dans l'élément de mémoire (30) au moyen du circuit électronique,
sachant que l'appareil électrique (35) est un participant de bus de terrain,
sachant que la partie inférieure est la partie inférieure d'un connecteur enfichable de raccordement et que la partie supérieure (6) est la partie supérieure (6) d'un connecteur enfichable de raccordement,
sachant que les lignes de bus de terrain mènent à la partie supérieure (6),
sachant que l'adresse de participant de l'appareil électrique (35), qui est prévue pour la transmission de données dans le bus de terrain, est mémorisée dans l'élément de mémoire (30) dans la partie supérieure (6) du connecteur enfichable de raccordement.

2. Appareil électrique selon la revendication 1, **caractérisé en ce que** l'élément de mémoire (30) est réalisé sous forme d'élément de mémoire électronique ou sous forme d'élément de mémoire mécanique, comme un commutateur DIP (5) ou analogues.

3. Appareil électrique selon au moins une des revendications précédentes, **caractérisé en ce que** des pilotes de bus de terrain sont prévus dans la partie supérieure (6) et/ou **en ce qu'**un câble en T pour bus de terrain est prévu dans la partie supérieure (6),
sachant en particulier que des lignes de bus de terrain sont dirigées de la prise correspondante au circuit électronique par l'intermédiaire de la connexion enfichable (8).

4. Appareil électrique selon au moins une des revendications précédentes, **caractérisé en ce que** la partie inférieure présente des tenons de guidage (4) pour empêcher le gauchissement lors de l'actionnement de la connexion enfichable (8) afin d'interconnecter les lignes de bus de terrain,
en particulier dans lesquels peuvent être vissées des vis d'assemblage (7) destinées à relier la partie supérieure (6) à la partie inférieure.

5. Appareil électrique selon au moins une des revendications précédentes, **caractérisé en ce qu'**un des modules présente un convertisseur de bus destiné à convertir des données dans le protocole de bus de terrain en données dans le protocole de bus système.

6. Appareil électrique selon au moins une des revendications précédentes, **caractérisé en ce que** les modules, en particulier les corps de refroidissement des modules, présentent sur deux côtés mutuellement opposés une interface telle qu'ils peuvent être reliés les uns aux autres en une ligne ou une rangée et forment ainsi le fond de l'appareil électrique.
